# EUROPEAN PATENT SPECIFICATION

(11) **EP 2 956 965 B1**
(45) Date of publication and mention of the grant of the patent: **28.06.2017**
(21) Application number: 14708318.2
(22) Date of filing: 13.02.2014
(51) Int. Cl.: H01L 27/144, H01L 31/02, H01L 27/146

(54) **DETECTOR APPARATUS AND METHOD**
DETEKTOR UND VERFAHREN
APPAREIL DÉTECTEUR ET MÉTHODE ASSOCIÉE

(30) Priority: 13.02.2013 GB 201302543
(43) Date of publication of application: 23.12.2015
(73) Proprietor: ISDI Limited, London NW5 1JN (GB)
(72) Inventor: ANAXAGORAS, Thalis, London NW1 9JN (GB)
(74) Representative: Yeadon IP Limited
(86) International application number: PCT/GB2014/050427
(87) International publication number: WO 2014/125286

(56) References cited:
- EP-A1- 1 233 459
- WO-A1-2012/007744
- US-A1- 2004 012 834
- US-A1- 2006 050 352

## Description

### FIELD OF THE INVENTION

The present invention relates to radiation detectors. In particular but not exclusively the invention relates to radiation detectors fabricated in silicon by means of CMOS wafer processing technologies.

### BACKGROUND

It is known to manufacture silicon strip detectors for position-sensitive detection of electromagnetic radiation. Silicon strip detectors were originally developed in the early 1980s and are typically employed in relatively large area detectors.

Known silicon strip detectors are fabricated by forming a one-dimensional (1 D) array of parallel strip-like doped regions (or stripes) in low-doped fully depleted silicon wafers, each doped region forming a PN junction with the substrate. Each stripe is connected to a charge sensitive amplifier and control electronics periodically reads out the charge on each stripe generated by exposure of the stripe to radiation. The radiation causes the generation of electron-hole pairs. This enables position-sensitive detection of carrier-generating radiation incident on the detector.

A 2D detector can be fabricated by forming a second strip detector on a reverse side of the wafer using double-sided wafer technology. The second strip detector is formed such that the parallel striped regions thereof are aligned parallel to a direction that is orthogonal to those on the front side of the wafer.

US2004/012834 discloses a method and device for the recording and processing of a signal. EP1233459 discloses a light-receiving device and photodetector comprising a light-receiving device.

### STATEMENT OF THE INVENTION

In one aspect of the invention for which protection is sought there is provided detector apparatus comprising: a first set of two or more first linear detector elements, each said first linear detector element comprising at least one photodiode device; and a second set of two or more second linear detector elements, each said second linear detector element comprising at least one photodiode device, the first and second sets of linear detector elements being arranged in an overlapping relationship, respective overlapping linear detector elements of the first and second sets being arranged in a substantially non-parallel relationship,
wherein the first and second sets of linear detector elements are provided in or on a substrate, and
wherein one or more of the first and/or second linear detector elements comprises a plurality of photodiode devices, the plurality of devices of the one or more of the first and/or second linear detector elements being coupled to one another in parallel.

It is to be understood that a first linear detector element that overlaps a second linear detector element is arranged to be substantially non-parallel to the second linear detector element.

It is to be understood that reference to linear is reference to a physical layout or structure of the detector elements rather than one or more electrical characteristics, which may be non-linear, or linear.

By overlapping is meant that a projection parallel to a first direction of the first linear detector elements onto a plane normal to the first direction overlaps or is at least partially superimposed on a projection along the first direction onto the same plane of the second linear detector elements. Thus, the projection of at least one first linear detector element on the plane intersects the projection onto that plane of at least one second linear detector element, said at least one first linear detector element and at least one second linear detector element being substantially non-parallel.

Some embodiments of the present invention have the advantage that detector apparatus may be formed in a convenient manner using well established photodiode fabrication technologies. For example, CMOS device process technologies may be employed to fabricate the detectors in some embodiments. Accordingly, in some embodiments radiation hard detector apparatus may be readily fabricated using known CMOS processes.

It is to be understood that by overlapping is meant that at least a portion of one set of linear detector elements overlaps at least a portion of the other set.

Optionally one of more of the first linear detector elements comprises a single strip photodiode device.

By strip photodiode device is meant a photodiode device in the form of a linear substantially continuous strip of doped semiconductor material. Thus one or more of the first linear detector elements may comprise only one strip photodiode device and not a plurality of photodiode devices. It is to be understood that a plurality of photodiode devices arranged in a linear chain may be considered to be strip-like, albeit they are formed from discrete, non-continuous doped wells, such as N-wells in a P-doped material or P-wells in an N-doped material.

Optionally each of the first linear detector elements comprises a single strip photodiode device.

Optionally each of the first linear detector elements comprises a plurality of photodiode devices.

Optionally one of more of the second linear detector elements comprises a single strip photodiode device.

Optionally each of the second linear detector elements comprises a single strip photodiode device.

Optionally each of the second linear detector elements comprises a plurality of photodiode devices.

Advantageously the substrate may be a semiconductor substrate, further advantageously a silicon substrate although other substrates may also be useful such as GaAs, GaN, sapphire and/or one or more other substrates.

Optionally the first and second sets of linear detector elements are arranged wherein respective orthogonal projections of the first and second sets of linear detector elements onto a plane parallel to a major face of the substrate overlap one another, respective overlapping linear detector elements being substantially non-parallel.

Optionally the respective orthogonal projections overlap over at least 50% of an area occupied by the respective projections.

Advantageously the respective orthogonal projections may overlap over at least 90% of an area occupied by the respective projections, optionally over substantially 100% of the area.

Optionally the first and second sets of linear detector elements define first and second radiation collection areas, wherein respective orthogonal projections of the first and second radiation collection areas onto a plane parallel to a major face of the substrate overlap one another.

Optionally the respective orthogonal projections of the first and second radiation collection areas overlap over at least 50% of an area occupied by the respective projections of the areas.

Optionally the respective orthogonal projections of the first and second radiation collection areas overlap over at least 90% of an area occupied by the respective projections of the areas, optionally over substantially 100% of the area.

Optionally, the detector may be operable to provide an output indicative of an intensity of radiation incident on the detector as function of position in two dimensions. The detector may therefore be described as a position-sensitive detector (PSD).

It is to be understood that, in the context of linear detector elements provided in or on a substrate, reference to superimposed or overlapping linear detector elements includes one set of linear detector elements being provided such that the set is at least partially superimposed on or at least partially overlaps another set of linear detector elements when the substrate is viewed along a direction parallel to the substrate normal. One set of linear detector elements may at least partially shadow the other when viewed parallel to the substrate normal.

As described above, it is to be understood that one or more linear detector elements of one or both sets of linear detector elements may comprise a plurality of spaced apart photodiode devices.

It is to be understood that where a linear detector element comprises a plurality of devices, the plurality of devices may be considered to form a strip, strip-like, row, chain, chain-like, stripe or stripe-like arrangement of devices. It is to be understood that, in some embodiments, whilst no photodiode of the plurality of photodiodes of which a given linear detector element is comprised may directly overlie a photodiode of a linear detector element of the other set with respect to a direction normal to a major face of the substrate, nevertheless the orthogonal projections of those linear detector elements onto a plane parallel to a major face of the substrate may still be superimposed on one another.

It is to be understood that, in use, a collection area of one or more photodiode devices of a linear detector element may become enlarged in a lateral direction at least such that collection areas of respective overlapping linear detector elements overlap one another. The lateral extent of the collection area may be controlled by adjusting the magnitude of a reverse bias potential applied to a photodiode, the lateral extent increasing with increasing reverse bias in some embodiments.

Optionally, one or more photodiode devices of the first and second sets of one or more linear detector elements are provided at a different level of the substrate to one or more other photodiode devices of the first and second sets.

Optionally, one or more photodiode devices of respective adjacent linear detector elements of a given set of linear detector elements are provided at different levels of the substrate.

Thus one or more photodiode devices of one linear detector element may be provided at a different level to one or more photodiode devices of an adjacent linear detector element.

Optionally, at least a plurality of photodiode devices of at least one linear detector element are provided at different levels of the substrate.

Optionally, respective adjacent photodiodes of at least one linear detector element are provided at different levels of the substrate.

Optionally, wherein the different levels correspond to different respective levels on substantially the same side of the substrate.

Alternatively, the different levels may correspond to respective opposite sides of the substrate.

Optionally, the photodiode devices of the first and second sets of one or more linear detector elements are provided at substantially the same level of the substrate.

Optionally, the photodiode devices of the first and second sets of one or more linear detector elements are provided on substantially the same side of the substrate.

As noted above, it is to be understood that in the case that the linear detector elements of the first and second sets of linear detector elements each comprise only a single photodiode device, the linear detector elements of the first and second sets may advantageously be provided at different respective levels, optionally on different sides of the substrate.

Optionally, the plurality of devices of the one or more linear detector elements are coupled in parallel by means of an electrically conductive signal line of the linear detector element.

The signal line may be formed from a metallic material such as copper, aluminium, silver, gold or any other metal or combination thereof. Other conductive materials such as a metal silicide, polysilicon or any other suitable material may be used.

Charge carriers generated by incident radiation and caused in use to flow in one of the linear detector elements may cause a current to flow along the linear detector element to a terminal thereof. In the case of a linear detector element comprising a plurality of photodiode devices the current may flow along a signal line of the linear detector element.

The linear detector elements or strip portions of a given set may be formed to be of any suitable pitch. By pitch is meant a centre-to-centre distance between respective adjacent linear detector elements or strip portions. The pitch may be around 1 micrometre in some embodiments although other values such as 10 micrometres, 20 micrometres, 50 micrometres, 100 micrometres, a value greater than 100 micrometres or any other suitable value are also useful.

Optionally, an orthogonal projection of one or more linear detector elements onto a plane parallel to a major face of the substrate has at least a portion that is substantially straight.

Optionally, the orthogonal projection of the one or more linear detector elements onto a plane parallel to a major face of the substrate is substantially straight along substantially a whole length thereof.

Optionally, orthogonal projections of two or more linear detector elements of a given set onto a plane parallel to a major face of the substrate are substantially straight and substantially parallel to one another.

Optionally, orthogonal projections of each of the linear detector elements of the first set onto a plane parallel to a major face of the substrate are substantially straight and substantially parallel to one another.

In other words, each of the linear detector elements of the first set of linear detector elements may be substantially straight and substantially parallel to one another.

Optionally, orthogonal projections of each of the linear detector elements of the second set onto a plane parallel to a major face of the substrate are substantially straight and substantially parallel to one another.

In other words, each of the linear detector elements of the second set of linear detector elements may be substantially straight and substantially parallel to one another.

Optionally, orthogonal projections of each of the linear detector elements of the first set onto a plane parallel to a major face of the substrate are substantially orthogonal to orthogonal projections of each of the linear detector elements of the second set onto said plane.

In other words, it is to be understood that the first and second sets of linear detector elements may be arranged with longitudinal axes of the linear detector elements of which they are comprised in respective substantially parallel planes. The longitudinal axes of the respective sets of linear detector elements may be arranged to be substantially non-parallel, optionally substantially orthogonal to one another. Thus the longitudinal axes of the linear detector elements of the first set may be substantially non-parallel to and optionally substantially orthogonal to the longitudinal axes of the linear detector elements of the second set.

Optionally, an orthogonal projection of one or more linear detector elements onto a plane parallel to a major face of the substrate has at least a portion that is substantially curved.

Optionally, one or more linear detector elements of one set of linear detector elements are substantially curved and one or more linear detector elements of the other set of linear detector elements are substantially straight.

Optionally, an orthogonal projection of one of more linear detector elements onto a plane parallel to a major face of the substrate is substantially in the form of a loop.

The loop may be in the form of an endless or substantially endless loop.

Optionally, the orthogonal projection of one of more linear detector elements onto a plane parallel to a major face of the substrate is substantially circular or elliptical.

Optionally, the orthogonal projection of the first or second set of linear detector elements onto a plane parallel to a major face of the substrate is in the form of substantially circular or elliptical elements and the orthogonal projection of the other set of linear detector elements onto a plane parallel to a major face of the substrate is in the form of substantially radially oriented elements with respect to the circular or elliptical projections of the first set of linear detector elements, optionally substantially straight, radially oriented elements.

Thus, in some embodiments the first and the second sets of linear detector elements may be arranged whereby one set is oriented radially and one in the form of substantially concentric circles, arcs or any other suitable arrangement. According to such an arrangement the radial linear detector elements may cross the arcuate or circular linear detector elements in a substantially orthogonal manner.

It is to be understood that in principle any suitable linear detector element shape may be realised. Linear detector element shapes may be formed at least in part by appropriate location of discrete devices, optionally coupled in parallel, or appropriate shapes of substantially continuous doped regions that may described any required shape in projection.

The apparatus may be configured to provide an output signal corresponding to an identity of the linear detector element in which charge carriers have been generated.

The signal corresponding to the identity may be a signal indicative of the location of the linear detector element

The output may provide an indication of the amount of charge carriers detected (corresponding for example to an integrated value of the current flowing through the one or more photodetectors of a given strip portion).

It is to be understood that one or more electronic readout circuits may be arranged to measure an amount of charge conducted through each output terminal over successive read cycle periods.

The detector may be operable to provide an output corresponding to the identity of the strip portion in which charge carriers have been detected over a given read cycle period.

The apparatus may be configured to provide an output signal corresponding to the amount of charge carriers generated in one or more or each linear detector element in a predetermined time period.

The time period may correspond to a read cycle period. The output provided by the detector may be in the form of a serial data stream, a parallel data stream or any other suitable data stream. The output may be in the form of an analogue signal in some embodiments, for example a multiplexed analogue signal.

The apparatus may comprise one or more electronic circuits configured to generate the output signal.

Optionally, the one or more electronic circuits may be configured to generate the output signal are provided in or on the substrate.

It is to be understood that because the circuits generating the output may be formed in the same substrate as the rows of photodiode devices, a detector may be provided in which the control electronics is integrated with the photodiode devices into the substrate. This allows the detector to be packaged in a more compact manner and may also reduce a cost of manufacture in some embodiments. In some arrangements, a speed at which the detector may operate may be increased due to a reduction in a maximum required length of a given signal line connecting a linear detector element to the control electronics (being integrated in or on the same substrate) and in some arrangements a reduction in an overall amount (measured by length) of wiring required. Well established CMOS processing technologies may be employed in some embodiments, enabling detectors to be fabricated in a reliable and reproducible manner.

In some embodiments a detector embodied in a single semiconductor substrate may be provided that is operable to provide an output corresponding to a location at which a packet of incident radiation has been detected. The output may be in the form of a coordinate, for example a Cartesian (X, Y) coordinate. That is, the detector may be arranged to provide substantially directly an output corresponding to the location of detected incident radiation in 2D. This feature greatly assists integration of the detector into a system, allowing a designer of the system to design the system without a requirement to gain a detailed understanding of the manner in which the detector operates. The output may in addition or instead provide data in respect of radiation intensity as a function of 2D position over the detector apparatus area, that is the collection area of the detector apparatus. The collection area may be defined as a carrier collection area, being an area in which carriers generated in that area by radiation may be collected and therefore detected.

As described above, the second set of linear detector elements may be formed on the same side of the substrate as the first set. Alternatively, the second set of strip portions may be formed on a reverse side of the substrate to the first set. In some embodiments, instead of being formed on opposite sides of the same wafer, the first and second set of strip portions may be formed on separate substrates which are then bonded to one another in a back to back configuration to form a single substrate. Thus the first set of strip portions may be provided on one side of the detector and the second set provided on the reverse side.

In some embodiments in which a linear detector element comprises a plurality of photodetector devices, two or more devices of the linear detector element may be formed with at least one device on the front and at least one device on the reverse sides of the wafer. Alternatively or in addition one linear detector element of one set of linear detector elements may be formed on one side of the substrate and another linear detector element of the same set may be formed on the opposite side of the substrate. Other arrangements are also useful.

As also described above, the first and second sets of linear detector element may be formed to lie substantially in the plane of the wafer.

In the case that at least a first set of linear detector elements comprises a plurality of photodiode devices, photodiode devices of the first set of linear detector elements may be arranged to overlie directly corresponding photodiode devices of the second set.

Alternatively the devices of respective sets of linear detector elements may be arranged to be offset laterally with respect to one another. That is, devices of the first set of linear detector elements may be offset with respect to those of the second set of linear detector elements in a direction that is orthogonal to a direction normal to a plane of the substrate.

The apparatus may further comprise a second array of pixel elements, each pixel element comprising one or more radiation detecting devices.

The second array may comprise a plurality of rows and columns of pixel elements, each row and each column comprising a plurality of pixel elements.

Optionally, the rows and columns are substantially orthogonal.

Optionally, the pixel elements of each row and column are individually addressable wherein a cumulative amount of charge generated in one or more radiation detecting devices of each pixel element may be read out from the array. The pixel elements may be described as active pixel sensors or elements (APS).

Optionally, the pixel elements of each row and column are individually addressable wherein a cumulative amount of charge generated in one or more radiation detecting devices of each pixel element in a predetermined time period may be read out from the array.

Optionally, the radiation detecting devices comprise at least one photodiode device.

The radiation detecting devices may each form part of a respective pixel element connectable to a signal line by means of one or more corresponding switching devices, optionally switching devices of the pixel element, to allow a state of the device to be read. The state of the device may be an indication as to an amount of radiation that has been incident on the device since the state of the device was last read out. Thus in some embodiments the device may be arranged to provide an indication of the amount of radiation incident on the device over a predetermined period of time.

Optionally, the second array of pixel elements is formed in or on the substrate in addition to the first and second sets of linear detector elements.

The second array may be an array of CMOS pixel elements or pixels comprising individually addressable radiation detecting devices such as photodiode devices.

It is to be understood that the second array of devices may be an array such as that described in co-pending international patent application PCT/GB2012/050316 (WO2012/107784)

Optionally, the second array is formed on the same side of the substrate as the first and second sets of linear detector elements.

Optionally, the second array is formed on the same side of the substrate as the first and second sets of linear detector elements but at a different level to the first and/or second sets.

For example the second array may be formed above or below the first and/or second sets, or between the first and second sets.

Optionally, the second array is formed on an opposite side of the substrate to the first and second sets of linear detector elements.

The second array may be formed on the same side of the substrate and laterally adjacent to the first and second sets of linear detector elements.

Alternatively, the second array may be formed to overlie or underlie at least partially the first and second sets of linear detector elements. The second array may be formed to be substantially coextensive with the first and second sets of linear detector elements. At least part of the second array may be formed on substantially the same level as the first and/or second sets of linear detector elements.

It is to be understood that embodiments of the invention having the second array at least partially superimposed on the linear detector elements as viewed parallel to the substrate normal have the advantage that data may be collected by two different data collection technologies in respect of the same radiation particles. Thus data obtained by means of linear detector element technology according to the present invention may be correlated with data obtained by means of the second array of pixel elements.

In some embodiments one or more pixels of the second array may be selectively disabled, or readout of incident radiation amount or intensity performed from a selected one or more pixels of the second array. Thus if readout of radiation intensity incident on a selected one or more portions of a collection area of the detector apparatus is required, readout of a corresponding one or more pixels of the second array may be made.

In addition or instead readout of an amount of incident radiation on a corresponding one or more portions of a collection area of the first and second sets of linear detector elements may be performed, or readout of an amount of incident radiation on substantially the whole of the collection area of the first and second sets of linear detector elements performed.

It is to be understood that embodiments of the present invention may be made suitable for the detection of packets of radiation with reduced crosstalk. It is to be understood that the size of a single photodiode of a linear detector elements may be small compared to a distance between devices of respective linear detector elements. Accordingly, charge generated by incident radiation may in some circumstances diffuse to a device that is not the closest device to the region of the device where the charge was generated, resulting in 'crosstalk' between photodiodes. It is be understood that outside the space charge region of a device, the electric field is relatively weak and charge carriers generated by a single packet of incident radiation may diffuse to multiple photodiode devices.

In one embodiment, in order to reduce crosstalk, back-thinning of the substrate is performed, optionally to thin the substrate to a thickness of around 30 micrometres in order to reduce lateral spread of charge. Other thicknesses are also useful.

In another embodiment, the thickness of the substrate may be maintained but regions of the substrate below each device may be isolated from the region below an adjacent device by a trench isolation technology. For example, high resistivity trenches may be cut sufficiently deep into the substrate (e.g. 450 micrometres deep). The trenches may be cut into a front side of the detector and/or a reverse side. The trenches may be formed by mechanical removal, ion etching or any other suitable method. In some embodiments the trenches may be filled with silicon dioxide (SiO2), silicon nitride (SiN) or any other suitable isolating material. The trenches may reduce significantly crosstalk between photodiodes.

It is to be understood that, in respect of the preceding and following aspects of the invention, and embodiments of the invention described herein, reference to photodiode device may be replaced by reference to a radiation sensitive device. That is, aspects and embodiments of the invention referred to as comprising a photodiode device may instead comprise any other suitable radiation sensitive device.

In one aspect of the invention for which protection is sought there is provided a radiation detector comprising a substrate, the substrate having a first set of two or more rows of photodiode devices formed thereon, each row comprising a plurality of photodiode devices connected in parallel. Charge carriers generated by incident radiation in one of the photodiodes of a given row are arranged in use to flow to a terminal at one end of the row where the carriers may be detected. The detector may be operable to provide an output corresponding to the identity of the row in which charge carriers have been detected. Alternatively or in addition the detector may be operable to provide an output corresponding to the amount of charge carriers generated in each row of the first set over a given period of time.

The detector may further comprise a second set of two or more rows of photodiode devices, each row of the second set of rows comprising a plurality of photodiode devices connected in parallel. The detector may be operable to detect charge carriers generated by incident radiation in a given row of the second set. The detector may be further operable to provide an output corresponding to the identity of the row of the second set in which charge carriers have been detected, optionally the identity of the row of the second set in which charge carriers have been detected over a given read cycle period. Alternatively or in addition the detector may be operable to provide an output corresponding to the amount of charge carriers generated in each row of the second set over a given period of time. The first and second sets of rows may be substantially orthogonal to one another although other arrangements may be useful.

The photodiode devices of a given row of the second set may be arranged in a substantially straight line. Respective rows of the second set may be arranged substantially parallel to one another.

It is to be understood that providing first and second rows of photodiode devices that are non-parallel, optionally orthogonal, has the advantage that a radiation detector having 2D spatial resolution may be provided. Advantageously the first and second rows of devices are arranged such that each device of the first row has an area that overlies or underlies a corresponding device of the second row as viewed along a direction substantially normal to a plane of the substrate. Thus a particle of radiation incident upon and passing through at least a portion of the substrate substantially parallel to the substrate normal may cause the generation of charge carriers in corresponding overlying devices of the first and second rows. Other arrangements are also useful.

In some embodiments a detector embodied in a single substrate, optionally a semiconductor substrate, may be provided that is operable to provide an output corresponding to a location at which a packet of incident radiation that has generated a sufficiently large number of electron-hole pairs has been detected. The output may be in the form of a coordinate such as an (X, Y) coordinate. That is, the detector may be arranged to provide substantially directly an output corresponding to the location of detected incident radiation in 2D. This feature greatly assists integration of the detector into a system, allowing a designer of the system to design the system without a requirement to gain a detailed understanding of the manner in which the detector operates.

The first set of rows of photodetector devices may be formed on the same side of the substrate as the second set. Alternatively, the first set of rows of photodetector devices may be formed on a reverse side of the wafer to the second set.

In some embodiments photodetector devices comprised by the first set of rows may be formed on front and reverse sides of the wafer. That is, one or more of the photodetector devices of the first set of rows may be formed on the front side and one or more formed on the reverse side. Alternatively or in addition, photodetectors comprised by the second set of rows may be formed on front and reverse sides of the wafer, i.e. one or more of the photodetector devices of the second set of rows may be formed on the front side and one or more formed on the reverse side. Devices of a given row may be formed on the same side of the substrate and respective rows formed on different sides. Alternatively respective devices of a given row may be formed on different sides of the substrate.

The first and second sets of rows may be formed to lie substantially in the same plane.

Alternatively the may be formed in different planes. For example, photodiode devices of the first set of rows may be arranged to overlie directly photodiode devices of the second set of rows. Alternatively photodiode devices of the first set of rows may be arranged to be offset laterally with respect to the devices of the second set of rows. That is, devices of the first set of rows may be offset with respect to those of the second set of rows in a direction that is orthogonal to a direction normal to a plane of the substrate.

In a further aspect of the invention for which protection is sought there is provided a method of detecting radiation comprising: providing detector apparatus according to any preceding aspect; and detecting radiation incident on the apparatus.

In one aspect of the invention for which protection is sought there is provided a position sensitive radiation detector operable to provide an output indicative of an intensity of radiation incident on the detector as function of position in two dimensions, the substrate having first and second sets of two or more elongate strip portions formed on one side thereof, each strip portion of the first set comprising at least one photodiode device, each strip portion of the second set comprising at least one photodiode device, the first and second strip portions being substantially superimposed on one another.

By superimposed is meant that one set of strip portions at least partially overlaps another set of strip portions when the substrate is viewed along a direction parallel to the substrate normal.

Embodiments of the invention have the advantage that a radiation hard detector may be formed in a convenient manner using well established photodiode fabrication technologies. For example, CMOS device process technologies may be employed to fabricate the detectors in some embodiments.

It is to be understood that in the case that the first and second sets of strip portions each comprise only a single photodiode device, the sets of strip portions may be formed at different respective levels on one side of the substrate.

At least one strip portion of the first set of photodiode strip portions may comprise a plurality of photodiode devices. Each of the strip portions of the first set of photodiode strip portions may comprise a plurality of photodiode devices. The photodiodes may be in the form of a chain of photodiodes, optionally coupled to one another, optionally coupled in parallel.

Alternatively or in addition, at least one strip portion of the second set of photodiode strip portions may comprise a plurality of photodiode devices. Each of the strip portions of the second set of photodiode strip portions may comprise a plurality of photodiode devices.

In the case that a strip portion comprises a plurality of photodiode devices, the devices of the strip portion may be coupled to one another in parallel. The devices may be coupled in parallel by means of any suitable conducting material such as metal, polysilicon or any other suitable material.

Charge carriers generated by incident radiation in one of the photodiodes of a given strip portion may be arranged in use to flow along a signal line to a terminal at one end of the strip portion where the carriers may be detected.

The strip portions of a given set may be formed to be of any suitable pitch. By pitch is meant a centre-to-centre distance between respective adjacent strip portions. The pitch may be around 1 micrometre in some embodiments although other values such as 10, micrometres, 20 micrometres, 50 micrometres, 100 micrometres, a value greater than 100 micrometres or any other suitable value are also useful.

The detector may be operable to provide an output corresponding to the identity of the strip portion in which charge carriers have been detected. The output may provide an indication of the amount of charge carriers detected (corresponding for example to an integrated value of the current flowing through the one or more photodetectors of a given strip portion.

It is to be understood that one or more electronic readout circuits may be arranged to measure an amount of charge conducted through each output terminal over successive read cycle periods.

The detector may be operable to provide an output corresponding to the identity of the strip portion in which charge carriers have been detected over a given read cycle period. The detector may be operable to provide an output corresponding to the amount of charge carriers detected in each strip portion over a given read cycle period. The output provided by the detector may be in the form of a serial data stream, a parallel data stream or any other suitable data stream. The output may be in the form of an analogue signal in some embodiments, for example a multiplexed analogue signal.

The photodiode devices of a given strip portion may be arranged in a substantially straight line. Respective strip portions of a given set of strip portions may be arranged substantially parallel to one another.

The first and second sets of strip portions may be arranged with longitudinal axes of the strip portions of which they are composed in respective substantially parallel planes. The longitudinal axes of the respective sets of strip portions may be arranged to be substantially orthogonal to one another.

In some alternative embodiments the first and the second set of strip portions may be formed whereby one set is oriented radially and one in the form of substantially concentric circles, arcs or any other suitable arrangement. According to such an arrangement the radial strip portions may cross the arcuate or circular strip portions in a substantially orthogonal manner.

It is to be understood that in principle any suitable strip shape may be realised with the appropriate construction of the conductive layer that connects the plurality of photodiodes forming each strip.

The detector may comprise one or more electronic circuits for providing the output. The one or more circuits may be formed in the substrate.

It is to be understood that because the circuits generating the output may be formed in the same substrate as the rows of photodiode devices, a detector may be provided in which the control electronics is integrated with the photodiode devices into the substrate. This allows the detector to be packaged in a more compact manner and may also reduce a cost of manufacture in some embodiments. In some arrangements, a speed at which the detector may operate may be increased due to a reduction in a maximum required length of a given signal line connecting a strip portion to the control electronics (being integrated on the same substrate) and in some arrangements a reduction in an overall amount (measured by length) of wiring required. Well established CMOS processing technologies may be employed in some embodiments, enabling detectors to be fabricated in a reliable and reproducible manner.

In some embodiments a detector embodied in a single semiconductor substrate may be provided that is operable to provide an output corresponding to a location at which a packet of incident radiation has been detected. The output may be in the form of a coordinate, for example a Cartesian (X, Y) coordinate. That is, the detector may be arranged to provide substantially directly an output corresponding to the location of detected incident radiation in 2D. This feature greatly assists integration of the detector into a system, allowing a designer of the system to design the system without a requirement to gain a detailed understanding of the manner in which the detector operates. The output may in addition or instead provide data in respect of radiation intensity as a function of 2D position over the detector area.

The second set of strip portions may be formed on the same side of the substrate as the first set. Alternatively, the second set of strip portions may be formed on a reverse side of the substrate to the first set. In some embodiments, instead of being formed on opposite sides of the same wafer, the first and second set of strip portions may be formed on separate substrates which are then bonded to one another in a back to back configuration. Thus the first set of strip portions may be provided on one side of the detector and the second set provided on the reverse side.

In some embodiments in which a strip portion comprises a plurality of photodetector devices, two or more devices of the strip portion may be formed with at least one device on the front and at least one device on the reverse sides of the wafer. Alternatively or in addition one strip portion of one set of strip portions may be formed on one side of the substrate and another strip portion of the same set may be formed on the opposite side of the substrate. Other arrangements are also useful.

The first and second sets of strip portions may be formed to lie substantially in the plane of the wafer.

In the case that at least a first set of strip portions comprises a plurality of photodiode devices, photodiode devices of the first set of strip portions may be arranged to overlie directly corresponding photodiode devices of the second set.

Alternatively the devices of respective sets of strip portions may be arranged to be offset laterally with respect to one another. That is, devices of the first set of strip portions may be offset with respect to those of the second set of strip portions in a direction that is orthogonal to a direction normal to a plane of the substrate.

In an embodiment, a second array of devices may be formed on the substrate in addition to the first and second sets of strip portions. The second array may be an array of CMOS pixel elements of pixels comprising individually addressable radiation detecting devices such as photodiode devices. The radiation detecting devices may each form part of a pixel element connectable to a signal line by means of one or more corresponding switching devices of the pixel element to allow a state of the device to be read. By state of the device is meant an indication as to whether radiation has been incident on the device since the state of the device was last read out. In some embodiments the device may be arranged to provide an indication of the amount of radiation incident on the device.

It is to be understood that the second array of devices may be an array such as that described in co-pending international patent application PCT/GB2012/050316.

The second array may comprise substantially orthogonal rows and columns of radiation detecting devices.

The second array may be formed on the same side of the substrate as the first and second sets of strip portions, optionally at a different level, for example on a level above or below. Alternatively the second array may be formed on an opposite side of the substrate to the first and second sets of strip portions. The second array may be formed on the same side of the substrate and laterally adjacent to the first and second sets of strip portions.

Alternatively, the second array may be formed to overlie or underlie at least partially the first and second sets of strip portions. The second array may be formed to be substantially coextensive with the first and second sets of strip portions. At least part of the second array may be formed on substantially the same level as the first and/or second sets of strip portions.

It is to be understood that embodiments of the invention having the second array at least partially superimposed on the strip portions as viewed parallel to the substrate normal have the advantage that data may be collected by two different data collection technologies in respect of the same radiation particles. Thus data obtained by means of strip detector technology according to the present invention may be correlated with data obtained by means of the second array of pixel elements.

It is to be understood that embodiments of the present invention may be made suitable for the detection of packets of radiation with reduced crosstalk. It is to be understood that the size of a single photodiode of a strip portion may be small compared to a distance between devices of respective strips. Accordingly, charge generated by incident radiation may in some circumstances diffuse to a device that is not the closest device to the region of the device where the charge was generated, resulting in 'crosstalk' between photodiodes. It is be be understood that outside the space charge region of a device, the electric field is relatively weak and charge carriers generated by a single packet of incident radiation may diffuse to multiple photodiode devices.

In one embodiment, in order to reduce crosstalk, back-thinning of the substrate is performed, optionally to thin the substrate to a thickness of around 30 micrometres in order to reduce lateral spread of charge. Other thicknesses are also useful.

In another embodiment, the thickness of the substrate may be maintained but regions of the substrate below each device may be isolated from the region below an adjacent device by a trench isolation technology. For example, high resistivity trenches may be cut sufficiently deep into the substrate (e.g. 450 micrometres deep). The trenches may be cut into a front side of the detector and/or a reverse side. The trenches may be formed by mechanical removal, ion etching or any other suitable method. In some embodiments the trenches may be filled with silicon dioxide (SiO2), silicon nitride (SiN) or any other suitable isolating material. The trenches may reduce significantly crosstalk between photodiodes.

In one aspect of the invention for which protection is sought there is provided a radiation detector comprising a substrate, the substrate having a first set of two or more rows of photodiode devices formed thereon, each row comprising a plurality of photodiode devices connected in parallel. Charge carriers generated by incident radiation in one of the photodiodes of a given row are arranged in use to flow to a terminal at one end of the row where the carriers may be detected. The detector may be operable to provide an output corresponding to the identity of the row in which charge carriers have been detected. Alternatively or in addition the detector may be operable to provide an output corresponding to the amount of charge carriers generated in each row of the first set over a given period of time.

The detector may further comprise a second set of two or more rows of photodiode devices, each row of the second set of rows comprising a plurality of photodiode devices connected in parallel. The detector may be operable to detect charge carriers generated by incident radiation in a given row of the second set. The detector may be further operable to provide an output corresponding to the identity of the row of the second set in which charge carriers have been detected, optionally the identity of the row of the second set in which charge carriers have been detected over a given read cycle period. Alternatively or in addition the detector may be operable to provide an output corresponding to the amount of charge carriers generated in each row of the second set over a given period of time. The first and second sets of rows may be substantially orthogonal to one another although other arrangements may be useful.

The photodiode devices of a given row of the second set may be arranged in a substantially straight line. Respective rows of the second set may be arranged substantially parallel to one another.

It is to be understood that providing first and second rows of photodiode devices that are non-parallel, optionally orthogonal, has the advantage that a radiation detector having 2D spatial resolution may be provided. Advantageously the first and second rows of devices are arranged such that each device of the first row has an area that overlies or underlies a corresponding device of the second row as viewed along a direction substantially normal to a plane of the substrate. Thus a particle of radiation incident upon and passing through at least a portion of the substrate substantially parallel to the substrate normal may cause the generation of charge carriers in corresponding overlying devices of the first and second rows. Other arrangements are also useful.

In some embodiments a detector embodied in a single substrate, optionally a semiconductor substrate, may be provided that is operable to provide an output corresponding to a location at which a packet of incident radiation that has generated a sufficiently large number of electron-hole pairs has been detected. The output may be in the form of a coordinate such as an (X, Y) coordinate. That is, the detector may be arranged to provide substantially directly an output corresponding to the location of detected incident radiation in 2D. This feature greatly assists integration of the detector into a system, allowing a designer of the system to design the system without a requirement to gain a detailed understanding of the manner in which the detector operates.

The first set of rows of photodetector devices may be formed on the same side of the substrate as the second set. Alternatively, the first set of rows of photodetector devices may be formed on a reverse side of the wafer to the second set.

In some embodiments photodetector devices comprised by the first set of rows may be formed on front and reverse sides of the wafer. That is, one or more of the photodetector devices of the first set of rows may be formed on the front side and one or more formed on the reverse side. Alternatively or in addition, photodetectors comprised by the second set of rows may be formed on front and reverse sides of the wafer, i.e. one or more of the photodetector devices of the second set of rows may be formed on the front side and one or more formed on the reverse side. Devices of a given row may be formed on the same side of the substrate and respective rows formed on different sides. Alternatively respective devices of a given row may be formed on different sides of the substrate.

The first and second sets of rows may be formed to lie substantially in the same plane.

Alternatively the may be formed in different planes. For example, photodiode devices of the first set of rows may be arranged to overlie directly photodiode devices of the second set of rows. Alternatively photodiode devices of the first set of rows may be arranged to be offset laterally with respect to the devices of the second set of rows. That is, devices of the first set of rows may be offset with respect to those of the second set of rows in a direction that is orthogonal to a direction normal to a plane of the substrate.

In an aspect of the invention for which protection is sought there is provided a detector comprising: a substrate; a first set of two or more strip portions, each strip portion comprising at least one photodiode device; and a second set of two or more strip portions, each strip portion comprising at least one photodiode device, the first and second strip portions being arranged wherein respective orthogonal projections of the first and second sets of strip portions onto a plane parallel to a major face of the substrate are substantially superimposed on one another.

Optionally, the detector may be operable to provide an output indicative of an intensity of radiation incident on the detector as function of position in two dimensions. The detector may therefore be described as a position-sensitive detector (PSD).

By superimposed is meant that one set of strip portions at least partially overlaps another set of strip portions when the substrate is viewed along a direction parallel to the substrate normal. That is, one set of strip portions at least partially shadows the other when viewed parallel to the substrate normal.

It is to be understood that one or more strip portions of one or both sets of strip portions may comprise a plurality of spaced apart photodiode devices. Where a strip portion comprises a plurality of devices, the plurality of devices may be considered to form a strip, row, chain or stripe-like arrangement of devices. It is to be understood that, in some embodiments, whilst no photodiode of the plurality of photodiodes of which a given strip portion is comprised may directly overlie a photodiode of a strip portion of the other set with respect to a direction normal to a major face of the substrate, nevertheless the orthogonal projections of those strip, row or stripe-like portions onto a plane parallel to a major face of the substrate may still be superimposed on one another.

Embodiments of the invention have the advantage that a radiation hard detector may be formed in a convenient manner using well established photodiode fabrication technologies. For example, CMOS device process technologies may be employed to fabricate the detectors in some embodiments.

Within the scope of this application it is envisaged that the various aspects, embodiments, examples, features and alternatives set out in the preceding paragraphs, in the claims and/or in the following description and drawings may be taken independently or in any combination. Features described with reference to one embodiment are applicable to all embodiments, unless there is incompatibility of features.

For the avoidance of doubt, it is to be understood that features described with respect to one aspect of the invention may be included within any other aspect of the invention, alone or in appropriate combination with one or more other features.

### BRIEF DESCRIPTION OF THE DRAWINGS

Embodiments of the invention will now be described with reference to the accompanying figures in which:
FIGURE 1 is a schematic illustration of a position sensitive detector according to an embodiment of the present invention in (a) plan view and (b) cross-section, and (c) a schematic illustration of a position sensitive detector according to a further embodiment of the present invention;
FIGURE 2 is a schematic illustration of a position sensitive detector according to a still further embodiment of the present invention;
FIGURE 3 is a schematic illustration of a position sensitive detector according to a further embodiment of the present invention;
FIGURE 4 is a schematic illustration of a position sensitive detector according to another further embodiment of the present invention; and
FIGURE 5 is a schematic illustration of a position sensitive detector including curved linear detector elements according (a) one embodiment of the present invention and (b) a further embodiment of the present invention.

### DETAILED DESCRIPTION

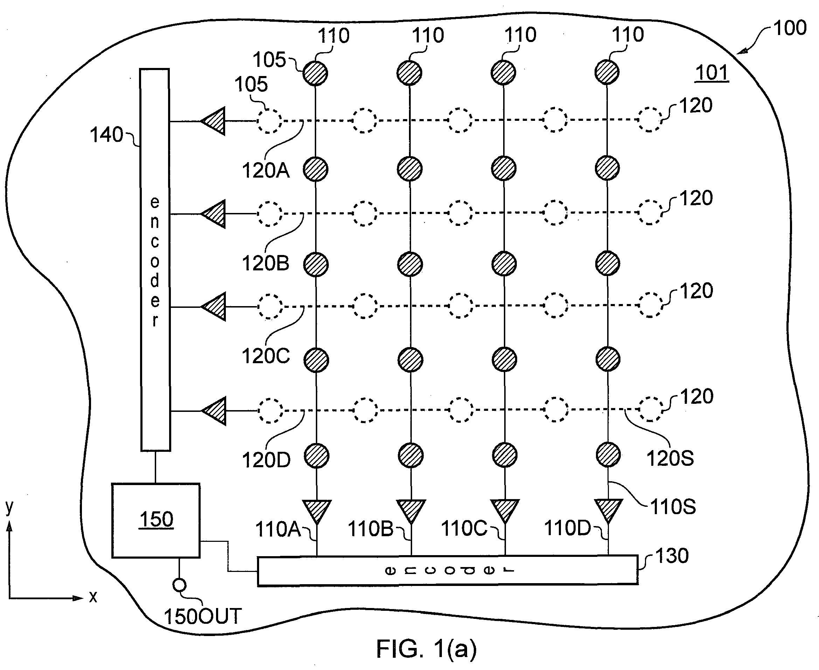

FIG.1 (a) shows a detector 100 according to an embodiment of the present invention. The detector may be described as a 'strip' detector in that it comprises arrays of linear detector elements. The linear detector elements may be described as 'strips' or 'stripes' in the sense that they are elongate, linear elements.

In the embodiment of FIG. 1(a), the detector 100 comprises a silicon wafer 101 on which are provided two orthogonal sets of linear detector elements in the form of rows or 'strips' or 'stripes' of photodiode devices 105. One linear detector element is therefore provided by one row, strip or stripe of photodiode devices 105. The rows may also be referred to as chains of devices since the devices are electrically coupled in a chain. In the embodiment shown the devices are electrically coupled in a chain in parallel.

A first set of rows 110 (rows 110A - 110D) is arranged to lie parallel to a Y axis whilst a second set of rows 120 (rows 120A-120D) is arranged to lie parallel to an X axis orthogonal to the Y axis. The X and Y axes both lie in the plane of the wafer 101. Each linear detector element, provided by rows 110, 120 of photodiode devices 105, has five photodiodes 105 whilst each set of rows 110, 120 has four rows 110, 120. The first set of rows 110 may be referred to as a set of columns 110.

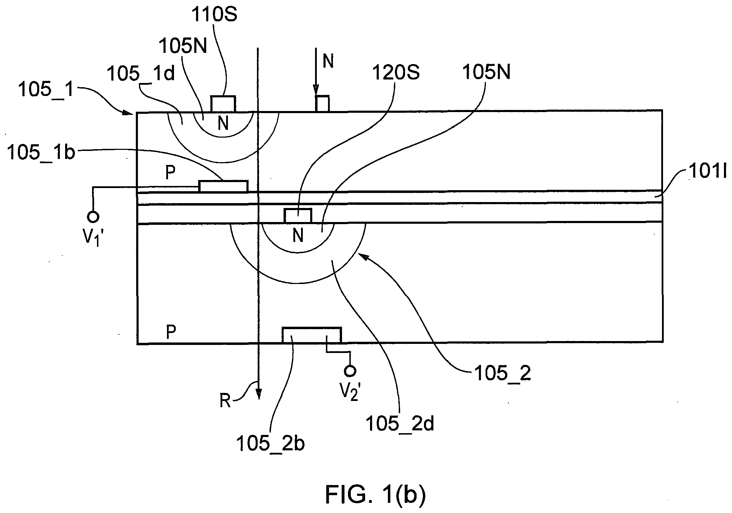

In the embodiment of FIG. 1(a) the first and second sets of rows 110, 120 are provided on the same side of the wafer 101. In some alternative embodiments the first and second sets of rows 110, 120 are provided on opposite sides of the wafer 101. In the embodiment shown the first and second rows 110, 120 are provided at different respective levels of the wafer 101 on the same side of the wafer 101. The first set of rows 110 are formed above the second set of rows 120 in the arrangement shown, the sets of rows 110, 120 being electrically isolated by means of an isolation layer 101I as shown in the cross-sectional view of FIG. 1(b).

The diodes 105 of a given row 110, 120 are connected in parallel by a respective signal line 110S, 120S and arranged to be reverse biased by a bias potential generated by respective first and second row-set controllers 130, 140. Depletion regions are established when the diodes are reverse biased, a lateral extent (parallel to the X-Y plane) and a thickness (or depth) of the depletion regions parallel to a Z-axis normal to the X-Y plane being dependent on the magnitude of the reverse bias potential applied. The diodes may be operated such that the depletion region associated with a diode in the first set of rows overlies the depletion region of a corresponding diode of the second set of rows as illustrated in FIG. 1(b) which shows a portion of the structure of FIG. 1(a) in cross section parallel to the Y direction.

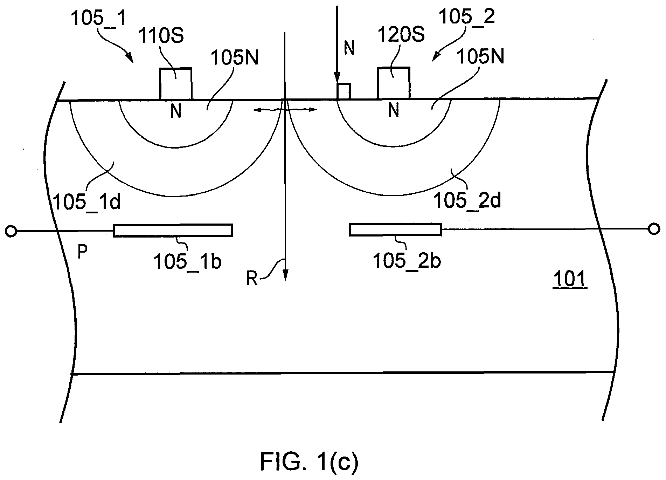

As shown in FIG. 1(b), depletion regions 105_1 d, 105_2d of photodiode devices 105_1, 105_2 of the first and second sets of rows 110, 120 established when a reverse bias is applied between signal lines 110S, 120S and respective back contacts 105_1b, 105_2b of the devices 105_1, 105_2 overlap when viewed along a direction parallel to substrate normal N. A particle R of radiation incident on the substrate 110 substantially parallel to the substrate normal N may generate charge carriers in the depletion region of diode 105_1, i.e. a diode of a row of the first set of rows 110 and diode 105_2, i.e. a diode of a row of the second set of rows 120. The respective charge carriers are detected by the first and second row-set controllers 130, 140 respectively. The same particle may therefore be detected by a diode of each of two orthogonal rows of diodes 105 enabling the 2D location of the particle with respect to the array of photodiodes 105 to be determined. It is to be understood that in the case of radiation in the form of a photon, the photon may in some cases be absorbed in the substrate 101, generating electron-hole pairs, only in or close to the depletion region of one of the diodes 105_1, 105_2 and not both. In this case, it may be advantageous to employ a structure in which the diodes of each orthogonal row are provided at substantially the same level and with depletion regions sufficiently close or overlapping such that electron-hole pairs generated between N-wells 105N of the devices 105 may be detected by both devices 105_1, 105_2. FIG. 1(c) illustrates an example of such a structure.

In the embodiment of FIG. 1(c), two adjacent diodes 105_1, 105_2 of different sets of rows 110, 120 are shown formed at a surface of the substrate 101. The N-wells 105N of each device 105_1, 105_2 are spaced apart laterally from one another. When a reverse bias potential is applied between signal lines 110S, 120S and respective back contacts 105_1b, 105_2b of the devices 105_1, 105_2, depletion regions 105_1d, 105_2d are established. In the arrangement shown a reverse bias potential has been applied sufficient to cause the depletion regions almost to overlap with one another. It can be seen that a particle of radiation R passing through the substrate 101 between the depletion regions 105_1d, 105_2d may generate electron-hole pairs in the region between the depletion regions, resulting in charge carriers being generated that cause current to follow in both devices 105_1, 105_2. It is to be understood that a particle of radiation passing through the depletion region of one of the devices 105_1, 105_2 but sufficiently close to the depletion region of the other device 105_1, 105_2 may generate charge carriers that are detectable by both devices 105_1, 105_2, i.e. which cause a detectable current to flow in both devices 105_1, 105_2.

In some embodiments the diodes 105 may be formed to be substantially square by forming substantially square N-wells 105N in a P-doped substrate (which may be lightly P doped) as viewed parallel to substrate normal N. In some embodiments P-wells may formed in an N-doped substrate instead. Other shapes of N-well or P-well such as hexagonally shaped wells or wells of any other suitable shape are also useful.

It is to be understood that higher resistivity substrates may be employed in order to enable larger depletion regions to be employed.

The controllers 130, 140 are arranged to measure current flowing through each row of the first and second sets of rows 110, 120 respectively over successive read cycle periods. The controllers 130, 140 integrate the amount of charge flowing through each row 110A-D of the first set of rows and each row 120A-D of the second set of rows over a given readout period. If the integrated amount of charge exceeds a threshold amount above a background level, the respective controller 130, 140 provides an output corresponding to the identity of the row of the first set of rows 110 or row of the second set of rows 120 in which this condition has been met, indicating that a packet of radiation has been detected by that row or column of devices 105. The output may additionally indicate the amount of the integrated charge. Thus the amount of carriers generated by one or more particles of radiation incident on the detector 100 at a given location may be determined in some embodiments. Other arrangements are also useful. For example in some embodiments, in addition or instead, the controllers 130, 140 may output signals corresponding the amount of carriers detected in each row 110, 120 over a prescribed period of time.

In the embodiment of FIG. 1 an output circuit 150 is provided that is arranged to correlate the signals output by the controllers 130, 140 and to generate an output signal 150OUT corresponding to a 2D location on the wafer 101 at which radiation has been detected. It is to be understood that, as described above, as a packet of incident radiation passes through the wafer 101, it may cause generation of charge carriers in a diode device 105 of the first set of rows 110 and a diode device 105 of the second set of rows 120. The 2D (X, Y) location at which the packet passes through the substrate 101 may be determined to correspond to that at which the rows 110, 120 in which charge carriers were detected intersect one another as viewed in a direction normal to the plane of the wafer 101, parallel to direction N.

In some embodiments, if radiation is detected by a photodiode 105 in each of rows 110A, 120A, the controller 150 may be configured to output a signal 150OUT identifying the location of the incident radiation as that at which rows 110A, 120A overlie one another (or in the case of the arrangement of FIG 1(c), cross one another). As noted above the output signal 150OUT may for example correspond to a coordinate, such as an (X, Y) coordinate. Other arrangements are also useful.

In some embodiments, in addition or instead the output circuit 150 may provide an output corresponding to an integrated value of the amount of current flowing through each respective row of the first and second sets of rows 110, 120 during a given read cycle period. This enables a computing or other device connected to the output 150OUT to determine the 2D spatial distribution of radiation incident on the detector 100 during a given read cycle period. In addition or instead the output circuit 150 may provide an output corresponding to the amount of charge carriers detected at each of a plurality of 2D locations. Thus in the case of a detector 100 having a first set of A rows of devices and a second set of B rows (or columns) of devices, the first and second sets being substantially orthogonal, the output circuit 150 may provide an output corresponding to the amount of charge carriers detected at each of (AxB) coordinates. For example if A=4 and B=4, the amount of charge carriers detected at each of 16 coordinate locations may be output.

The wafer 101 may be a silicon wafer, for example a (100) wafer, (111) wafer, (110) wafer or any other suitable wafer. The detector 100 may be configured to detect radiation such as photons in one or more selected from amongst the infra-red (IR) region of the electromagnetic spectrum (EMS), the far-IR region, the near-IR region, the visible region or the ultra-violet region. Alternatively or in addition the detector 100 may be arranged to detect at least one selected from amongst neutron radiation, proton radiation, gamma radiation, electrons, ions or any other suitable type of radiation or particle. Detectors 100 are contemplated that are optimised to detect any prescribed type of particle that can generate charge carriers in a photodiode device such as electron-hole pairs.

It is to be understood that in order to detect certain types of radiation it may be necessary to thin the substrate or wafer, and/or provide electrical isolation between adjacent devices. Electrical isolation may be provided by the use of a trench isolation technology in some embodiments. Other arrangements are also useful.

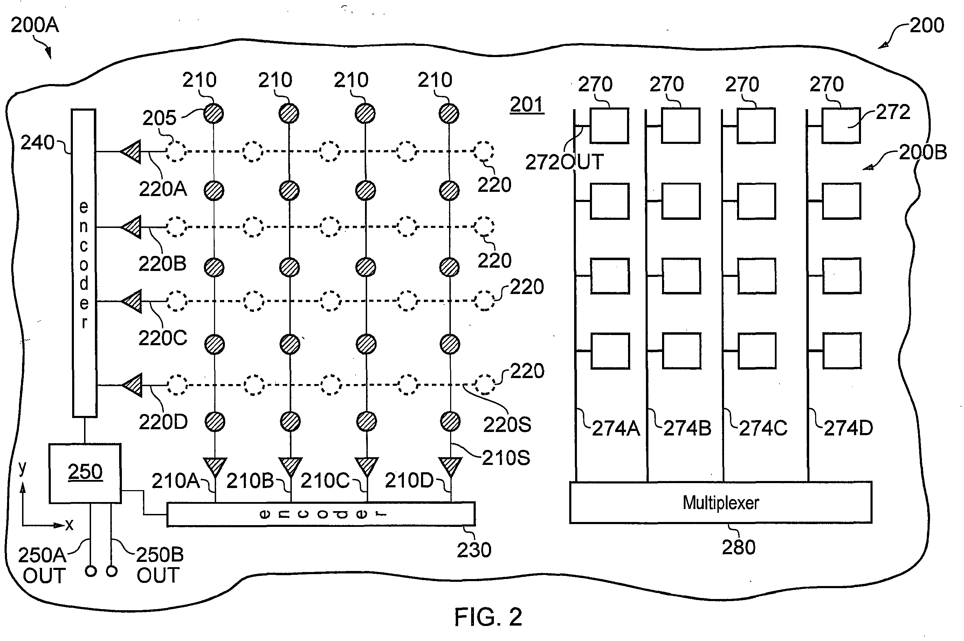

FIG. 2 is a schematic illustration of a detector 200 according to a further embodiment of the invention. The detector 200 has a strip detector portion 200A and a pixel array portion 200B. Like features of the embodiment of FIG. 2 to those of the embodiments of FIG. 1(a) to (c) are shown with like reference signs incremented by 100.

In the embodiment of FIG. 2 the strip detector portion 200A is similar to that of the embodiment of FIG. 1 except that an output circuit 250 of the detector 200 is configured to provide one output signal from signal line 250AOUT in respect of strip detector portion 200A and one output signal from signal line 250BOUT in respect of pixel array portion 200B.

The pixel array portion 200B comprises an array of pixel elements 272 in the form of four rows 270 each having four pixel elements 272. The pixel elements 272 of a given row 270 are connected to a row controller 280 by means of a signal line 274A-D. The row controller 280 is in the form of a multiplexer operable to address individual pixel elements 272 to read out a potential at each pixel element 272.

In use, the pixel elements 272 of a given row are connected in turn to the row controller 280 and a potential at an output of each element 272 is measured. The controller 280 outputs a series of signals that correspond to the potential at the output of each element 272 to the output circuit 250. The signals may be output in a serial data form in some embodiments and a parallel data form in some other embodiments. Other output forms are also useful.

In the embodiment of FIG. 2 the pixel array portion 200B is provided laterally adjacent the strip detector portion 200A.

In alternative embodiments the pixel array portion 200B may be arranged to overlie or underlie the strip detector portion 200A. In one embodiment the strip detector portion 200A is provided on an opposite side of the substrate 201 to the pixel array portion 200B.

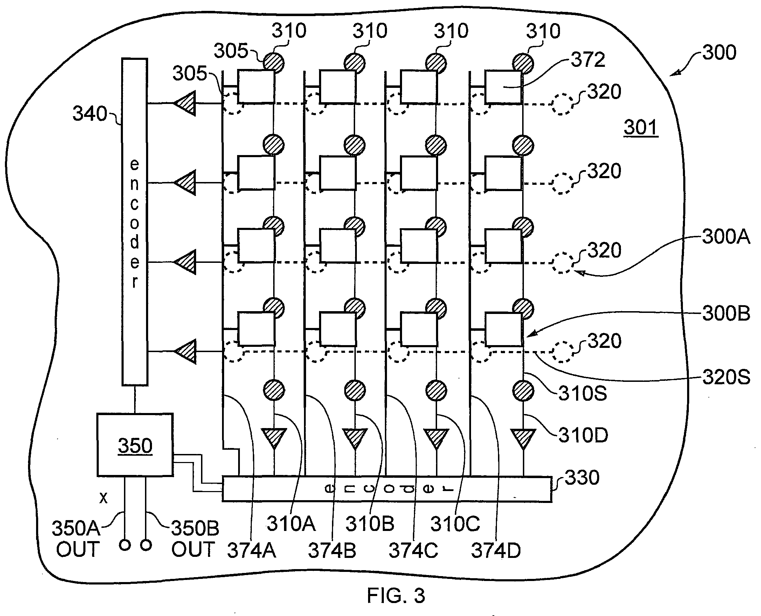

FIG. 3 shows a detector 300 according to a further embodiment of the invention. Like features of the embodiment of FIG. 3 to the embodiment of FIG. 2 are shown with like reference signs incremented by 100. In the embodiment of FIG. 3 a detector 300 is provided in which a pixel array portion 300B is provided above a strip detector portion 300A on the same side of a substrate 301.

The strip detector portion 300A of the embodiment of FIG. 3 is similar to the strip detector portion 200A of the embodiment of FIG. 2, and the pixel array portion 300B of the embodiment of FIG. 3 is similar to the pixel array portion 200B of the embodiment of FIG. 2.

In the embodiment of FIG. 3 the pixel array portion 300B is formed in a layer of silicon deposited above the portion of the substrate 301 in which the strip detector portion 300A is formed although other arrangements are also useful. In the embodiment of FIG. 3 a first row set controller 330 controlling the first set of rows 310 of the strip detector portion 300A is also configured to receive output signals from the pixel array portion 300B. The controller 330 processes the signals received and provides an output to the output circuit 350 corresponding to (a) the integrated amount of current flowing through each row 310 of photodiodes of the strip detector portion 300A during a given readout cycle; and (b) the amount of charge collected by a photodiode of each pixel element 372 of the pixel array portion 300B. In some embodiments a separate controller processes signals from the pixel array portion 300B. Other arrangements are also useful.

The embodiment of FIG. 3 has the advantage that data in respect of the intensity of radiation falling on a given area may be measured by two different detector technologies substantially simultaneously. Alternatively, in some embodiments a user may select which detector technology they wish to employ and disable the other.

It is to be understood that a detector according to some embodiments of the invention having a plurality of parallel strip portions may be operated with two or more adjacent strip portions connected to one another to form a single row in order to increase the integrated amount of charge measured over a given read cycle. This process may be referred to as binning and reduces the signal to noise ratio (SNR) associated with a given measurement. Binning may be useful where the pitch of rows of pixel elements is less than that required for the particular use to which the detector is being put, allowing adjacent rows to be 'combined' to form an 'effective' row of larger area. Thus for example if a pitch of 100µm is sufficient for a given measurement, and a detector of 5µm pitch is employed, rows of the detector may be 'binned' such that readout of charge from several groups of rows (e.g. groups of 20 rows) may be made to obtain effective readouts from a single 'effective' row comprising 20 rows of devices. Other arrangements are also useful.

In an alternative configuration, in some embodiments alternate rows 110, 120 (or any other combination of rows 110, 120) may be provided with a reverse bias potential that is greater (more heavily reverse biased) than that applied to the remaining rows. In order to achieve this, the reverse bias applied to the remaining rows may be reduced from that which they are normally subjected to in order to decrease their carrier collection efficiency. The bias potential applied to the more heavily reverse biased rows is arranged to be sufficiently high to draw carriers generated within the area of devices 105 of adjacent rows to which the lower (or no) reverse bias potential has been applied. The reverse bias potential may be made more highly reverse biased relative to that which would otherwise be applied or remain substantially unchanged whilst that applied to the other alternate rows is decreased. In other words in some embodiments the devices 105 to which a heavier reverse bias potential has been applied may be arranged to have a sufficiently large depletion region that carriers may be collected by those devices 105 that would otherwise have been collected by devices of an adjacent row 110, 120 if all rows had substantially the same reverse bias applied thereto. This feature enables a row to which the higher reverse bias potential has been applied to collect more carriers. A reduction in signal to noise ratio associated with the signal collected from such rows 110, 120 may thereby be enjoyed. This method of reducing the SNR may be referred to as a form of binning.

As noted the remaining rows 110, 120 may in some embodiments have substantially no reverse bias applied thereto so that they do not collect charge carriers generated by incident radiation.

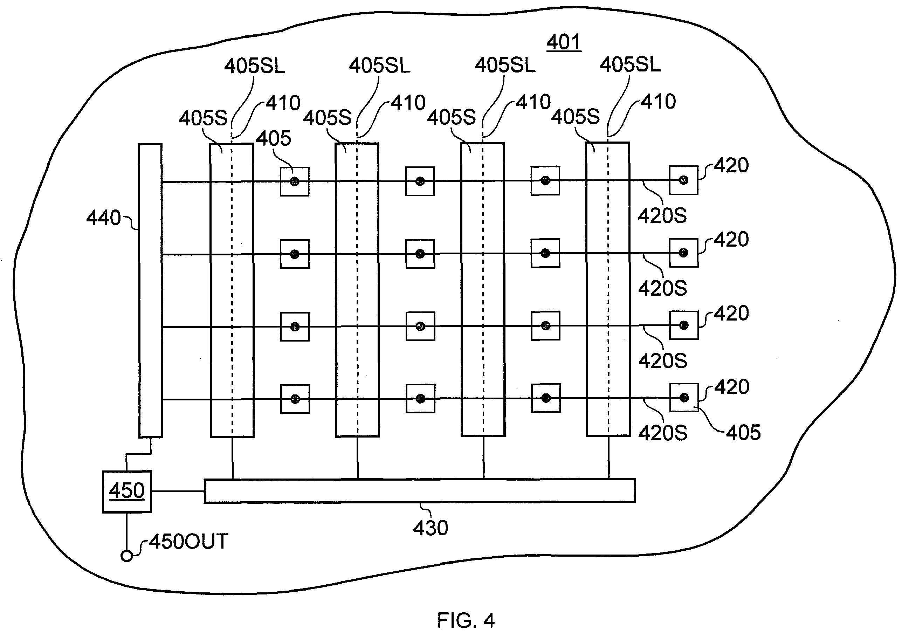

FIG. 4 shows a detector 400 according to a further embodiment of the invention. The detector 400 comprises two orthogonal sets of strip portions 410, 420. Like features of the embodiment of FIG. 4 to those of the embodiment of FIG. 3 are provided with like reference signs incremented by 100.

A first set of strip portions 410 are each composed of a single elongate strip or stripe-shaped photodiode 405S. The stripe-shaped photodiodes 405S are arranged with their longitudinal axes 405SL substantially parallel to one another. Thus the N-wells of the photodiodes 405S are in the form of elongate, linear stripes in the embodiment of FIG. 4. P-wells may be formed in the case that PMOS photodiode devices are employed.

A second set of strip portions are each composed of a row 420 of substantially square-shaped photodiode devices 405. The rows 420 are arranged substantially normal to the longitudinal axes 405SL of the rows of stripe-shaped photodiodes 405S. Respective adjacent photodiode devices 405 of a given row 420 are provided to one side of respective adjacent stripe-shaped photodiode devices 405S. The devices 405 of a given row 420 are connected in parallel by means of a signal line 420S.

In some alternative embodiments a detector is provided similar to that of the embodiment of FIG. 4 except that each strip portion 410, 420 of both the first and second sets of strip portions 410, 420 is provided by a single elongate stripe-shaped photodiode 405S. It is to be understood that in this case the strip portions 405S of respective sets of strip portions 410, 420 may be formed at different respective levels, one above the other, on one side of the substrate 401 or on opposite sides of the substrate. Other arrangements may also be useful.

In some embodiments respective sets of strip portions 110, 120, 210, 220, 310, 320, 410, 420 may be formed on opposite sides of the substrate. Other arrangements may also be useful.

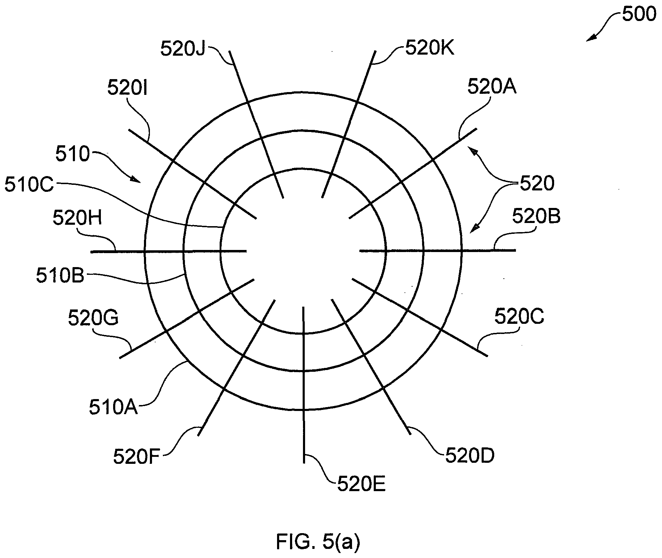

FIG. 5(a) shows a detector device 500 according to a further embodiment of the present invention. Like features of the embodiment of FIG. 5(a) to those of the embodiment of FIG. 4 are provided with like reference signs incremented by 100.

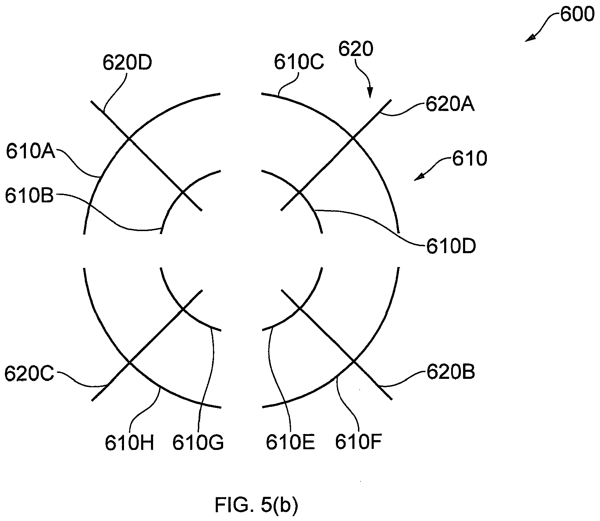

In the embodiment of FIG. 5(a) the detector 500 has first and second sets of linear detector elements 510, 520. The first set of linear detector elements 510 comprises three substantially circular, concentric rings of linear detector elements 510A, 510B, 510C. The second set of linear detector elements 520 comprises substantially straight linear detector elements 520A-K arranged in a substantially radially arrangement with respect to the circular rings of detector elements 510A-C. It can be seen that in the embodiment of FIG. 5, the linear detector elements of the first and second sets 510, 520 intersect one another substantially at right-angles as viewed parallel to a direction normal to the substrate 501, being the view presented in FIG. 5(a).

It is to be understood that in some alternative embodiments the linear detector elements of the first set may be elliptical rather than circular. Other arrangements are also useful. For example the substantially continuous linear detector elements of the first set may instead by segmented, for example a single circular linear detector element may instead be formed by two or more arcuate linear detector elements.

Similarly the second set of linear detector elements may be curved, optionally arcuate, rather than substantially straight.

FIG. 5(b) shows an embodiment of the invention similar to that of FIG. 5(a) and like features of the embodiment of FIG. 5(b) to those of the embodiment of FIG. 5(a) are shown with like reference signs incremented by 100. In the embodiment of FIG. 5(b) a first set of linear detector elements 610 is formed from eight quadrants 610A-H, whilst a second set of linear detector elements is formed from four substantially straight linear detector elements 620A-D.

The eight quadrants 610A-H are arranged in two concentric rings of quadrants, one ring of quadrants 610B, 610D, 610F, 610H surrounding the other ring of quadrants 610A, 610C, 610E, 610G, the rings being substantially concentric.

It is to be understood that either or both of the first and second sets of linear detector elements may comprise one or more photodiode devices. Again, in a similar manner to the embodiment of FIG. 4, in the case that a given linear detector element is provided by a single photodiode device, the device may be in the form of a substantially circular, elliptical, arcuate or substantially straight N-well formed in a P-doped substrate, optionally a lightly P-doped substrate, or P-well formed in an N-doped substrate, optionally a lightly N-doped substrate. Other shapes of linear detector element are also useful.

In the case that a given linear detector element is formed from a plurality of photodiode devices, the devices may be provided in a chain that forms a substantially circular, linear arrangement, or an elliptical, arcuate or substantially straight linear arrangement. Other arrangements are useful. The photodiode devices may be NMOS devices in some embodiments, and PMOS devices in some other embodiments.

It is to be understood that in some embodiments, one or more linear detector elements may be formed from NMOS devices and one or more detector elements formed from PMOS devices that are formed in a single semiconductor substrate, to form a detector according to an embodiment of the present invention.

The respective sets of linear detector elements may be formed at different respective levels of a substrate or at the same level, depending on the particular configuration, as described elsewhere herein.

Throughout the description and claims of this specification, the words "comprise" and "contain" and variations of the words, for example "comprising" and "comprises", means "including but not limited to", and is not intended to (and does not) exclude other moieties, additives, components, integers or steps.

Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith.

## Claims

1. Detector apparatus (100) comprising:
a first set (110) of two or more first linear shaped detector elements (110A-D), each said first linear detector element (110A-D) comprising at least one photodiode device (105); and
a second set (120) of two or more second linear shaped detector elements (120A-D), each said second linear detector element (120A-D) comprising at least one photodiode device (105),
the first and second sets of linear detector elements (110, 120) being arranged in an overlapping relationship, respective overlapping linear detector elements (110A-D, 120A-D) of the first and second sets (110, 120) being arranged in a substantially non-parallel relationship,
wherein the first and second sets of linear detector elements (110, 120) are provided in or on a substrate (101), and
wherein one or more of the first and/or second linear detector elements (110A-D, 120A-D) comprises a plurality of photodiode devices (105), **characterised in that**
the plurality of devices (105) of the one or more of the first and/or second linear detector elements (110A-D, 120A-D) are coupled to one another in parallel.

2. Apparatus (100) according to claim 1 wherein the first and second sets of linear detector elements (110, 120) are arranged wherein respective orthogonal projections of the first and second sets of linear detector elements onto a plane parallel to a major face of the substrate (101) overlap one another, respective overlapping linear detector elements (110, 120) being substantially non-parallel.

3. Apparatus (100) according to claim 2 wherein the respective orthogonal projections overlap over at least 50% of an area occupied by the respective projections.

4. Apparatus (100) according to any preceding claim wherein one or more photodiode devices (105) of the first and second sets (110, 120) of one or more linear detector elements are provided at a different level of the substrate to one or more other photodiode devices (105) of the first and second sets (110, 120).

5. Apparatus (100) according to claim 4 wherein one or more photodiode devices (105) of respective adjacent linear detector elements (110A-D, 120A-D) of a given set of linear detector elements (110, 120) are provided at different levels of the substrate (101).

6. Apparatus (100) according to any preceding claim wherein the photodiode devices (105) of the first and second sets of two or more linear detector elements (110, 120) are provided at substantially the same level of the substrate (101).

7. Apparatus (100) according to claim 6 wherein the photodiode devices (105) of the first and second sets of two or more linear detector elements (110, 120) are provided on substantially the same side of the substrate (101).

8. Apparatus (100) according to any preceding claim wherein orthogonal projections of each of the linear detector elements (110A-D) of the first set (110) onto a plane parallel to a major face of the substrate (101) are substantially straight and substantially parallel to one another;
wherein orthogonal projections of each of the linear detector elements (120A-D) of the second set (120) onto a plane parallel to a major face of the substrate (101) are substantially straight and substantially parallel to one another; and
wherein orthogonal projections of each of the linear detector elements (110A-D) of the first set (110) onto a plane parallel to a major face of the substrate (101) are substantially orthogonal to orthogonal projections of each of the linear detector elements (120A-D) of the second set (120) onto said plane.

9. Apparatus (100) according to any preceding claim wherein an orthogonal projection of one or more linear detector elements (110A-D, 120A-D) onto a plane parallel to a major face of the substrate (101) has at least a portion that is substantially curved.

10. Apparatus (100) according to claim 9 wherein one or more linear detector elements (110A-D, 120A-D) of one set of linear detector elements (110, 120) are substantially curved and one or more linear detector elements of the other set (120, 110) of linear detector elements are substantially straight.

11. Apparatus (500) according to claim 9 or 10 wherein an orthogonal projection of one of more linear detector elements (510A-C) onto a plane parallel to a major face of the substrate (101) is substantially in the form of a loop.

12. Apparatus (100) according to any preceding claim configured to provide an output signal corresponding to the amount of charge carriers generated in one or more or each linear detector element (110A-D, 120A-D) in a predetermined time period, the apparatus (100) comprising one or more electronic circuits (150) configured to generate the output signal.

13. Apparatus according to any preceding claim further comprising a second array of pixel elements, each pixel element comprising one or more radiation detecting devices.

14. Apparatus according to claim 13 wherein the second array comprises a plurality of rows and columns of pixel elements, each row and each column comprising a plurality of pixel elements, wherein the rows and columns are substantially orthogonal, and wherein the pixel elements of each row and column are individually addressable wherein a cumulative amount of charge generated in one or more radiation detecting devices of each pixel element may be read out from the array, and wherein the radiation detecting devices comprise at least one photodiode device.

15. A method of detecting radiation comprising:
providing detector apparatus (100) according to any preceding claim; and
detecting radiation incident on the apparatus (100).

## Patentansprüche

1. Detektorvorrichtung (100), umfassend:
Einen ersten Satz (110) von zwei oder mehreren ersten linear geformten Detektorelementen (110A-D), wobei jedes besagte erste lineare Detektorelement (110A-D) wenigstens ein Fotodiodengerät (105) umfasst; und
einen zweiten Satz (120) von zwei oder mehreren zweiten linear geformten Detektorelementen (120A-D), wobei jedes besagte zweite lineare Detektorelement (120A-D) wenigstens ein Fotodiodengerät (105) umfasst,
wobei die ersten und zweiten Sätze linearer Detektorelemente (110, 120) in einer überlappenden Beziehung angeordnet sind, wobei jeweilige überlappende lineare Detektorelemente (110A-D,120A-D) der ersten und zweiten Sätze (110, 120) in einer im Wesentlichen nicht parallelen Beziehung angeordnet sind,
wobei die ersten und zweiten Sätze linearer Detektorelemente (110, 120) in oder auf einem Substrat (101) bereitgestellt sind, und
wobei eins oder mehrere der ersten und/oder zweiten linearen Detektorelemente (110A-D,120A-D) eine Vielzahl von Fotodiodengeräten (105) umfasst, **dadurch gekennzeichnet, dass**
die Vielzahl von Geräten (105) des einen oder der mehreren der ersten und/oder zweiten Detektorelemente (110A-D, 120A-D) in Parallelschaltung aneinandergekoppelt sind.

2. Vorrichtung (100) nach Anspruch 1, wobei die ersten und zweiten Sätze linearer Detektorelemente (110, 120) angeordnet sind, wobei jeweilige orthogonale Projektionen der ersten und zweiten Sätze linearer Detektorelemente auf eine Ebene parallel zu einer Hauptfläche des Substrats (101) einander überlappen, wobei jeweilige überlappende lineare Detektorelemente (110, 120) im Wesentlichen nicht parallel sind.

3. Vorrichtung (100) nach Anspruch 2, wobei sich die jeweiligen orthogonalen Projektionen über wenigstens 50% einer Fläche überlappen, die von den jeweiligen Projektionen eingenommen wird.

4. Vorrichtung (100) nach einem vorhergehenden Anspruch, wobei ein oder mehrere Fotodiodengeräte (105) der ersten und zweiten Sätze (110, 120) eines oder mehrerer linearer Detektorelemente mit einer unterschiedlichen Ebene des Substrats zu einer oder mehreren anderen Fotodiodengeräten (105) der ersten und zweiten Sätze (110, 120) versehen sind.

5. Vorrichtung (100) nach Anspruch 4, wobei eins oder mehrere Fotodiodengeräte (105) der jeweiligen angrenzenden linearen Detektorelemente (110A-D, 120A-D) eines gegebenen Satzes linearer Detektorelemente (110, 120) an unterschiedlichen Ebenen des Substrats (101) bereitgestellt sind.

6. Vorrichtung (100) nach einem vorhergehenden Anspruch, wobei die Fotodiodengeräte (105) der ersten und zweiten Sätze von zwei oder mehreren linearen Detektorelementen (110, 120) im Wesentlichen an der gleichen Ebene des Substrats (101) bereitgestellt sind.

7. Vorrichtung (100) nach Anspruch 6, wobei die Fotodiodengeräte (105) der ersten und zweiten Sätze von zwei oder mehreren linearen Detektorelementen (110, 120) im Wesentlichen auf der gleichen Seite des Substrats (101) bereitgestellt sind.

8. Vorrichtung (100) nach einem vorhergehenden Anspruch, wobei orthogonale Projektionen jedes der linearen Detektorelemente (110A-D) des ersten Satzes (110) auf eine Ebene parallel zu einer Hauptfläche des Substrats (101) im Wesentlichen gerade und wesentlich parallel zueinander sind;
wobei orthogonale Projektionen jedes der linearen Detektorelemente (120A-D) des zweiten Satzes (120) auf eine Ebene parallel zu einer Hauptfläche des Substrats (101) im Wesentlichen gerade und wesentlich parallel zueinander sind; und
wobei orthogonale Projektionen jedes der linearen Detektorelemente (110A-D) des ersten Satzes (110) auf eine Ebene parallel zu einer Hauptfläche des Substrats (101) im Wesentlichen orthogonal zu orthogonalen Projektionen jedes der linearen Detektorelemente (120A-D) des zweiten Satzes (120) auf die Ebene sind.

9. Vorrichtung (100) nach einem vorhergehenden Anspruch, wobei eine orthogonale Projektion von einem oder mehrerer linearer Detektorelemente (110A-D, 120A-D) auf eine Ebene parallel zu einer Hauptfläche des Substrats (101) wenigstens einen Abschnitt aufweist, der im Wesentlichen gekrümmt ist.

10. Vorrichtung (100) nach Anspruch 9, wobei ein oder mehrere lineare Detektorelemente (110A-D, 120A-D) eines Satzes linearer Detektorelemente (110, 120) im Wesentlichen gekrümmt sind und eins oder mehrere lineare Detektorelemente des anderen Satzes (120, 110) der linearen Detektorelemente im Wesentlichen gerade sind.

11. Vorrichtung (500) nach Anspruch 9 oder 10, wobei eine orthogonale Projektion eines oder mehrerer linearer Detektorelemente (510A-C) auf eine Ebene parallel zu einer Hauptfläche des Substrats (101) im Wesentlichen in Form einer Schleife ist.

12. Vorrichtung (100) nach einem vorhergehenden Anspruch, die konfiguriert ist, ein Ausgangssignal bereitzustellen, das der Menge von Ladungsträgern entspricht, die in einem oder mehreren oder jedem linearen Detektorelement (110A-D, 120A-D) in einem vorbestimmten Zeitraum generiert werden, wobei die Vorrichtung (100) eine oder mehrere elektronische Schaltungen (150) umfasst, die konfiguriert sind, das Ausgangssignal zu generieren.

13. Vorrichtung nach einem vorhergehenden Anspruch, die ferner eine zweite Anordnung von Pixelelementen umfasst, wobei jedes Pixelelement ein oder mehrere Geräte zur Detektion von Strahlung umfasst.

14. Vorrichtung nach Anspruch 13, wobei die zweite Anordnung eine Vielzahl von Reihen und Spalten von Pixelelementen umfasst, jede Reihe und jede Spalte eine Vielzahl von Pixelelementen umfasst, wobei die Reihen und Spalten im Wesentlichen orthogonal sind, und wobei die Pixelelemente jeder Reihe und Spalte individuell adressierbar sind, wobei eine kumulative Lademenge, die in einem oder mehreren der Geräte jedes Pixelelements zur Detektion von Strahlung generiert wird, aus der Anordnung abgelesen werden könnte, und wobei die Geräte zur Detektion von Strahlung wenigstens ein Fotodiodengerät umfassen.

15. Verfahren zur Detektion von Strahlung, umfassend: Bereitstellen einer Detektorvorrichtung (100) nach einem vorhergehenden Anspruch; und Detektieren eines Strahlungseinfalls auf die Vorrichtung (100).

## Revendications

1. Appareil détecteur (100) comprenant :
un premier ensemble (110) de deux ou plusieurs premiers éléments détecteurs de forme linéaire (110A-D), chacun desdits premiers éléments détecteurs linéaires (110A-D) comprenant au moins un dispositif à photodiode (105) ; et
un second ensemble (120) de deux ou plusieurs seconds éléments détecteurs de forme linéaire (120A-D), chacun desdits seconds éléments détecteurs linéaires (120A-D) comprenant au moins un dispositif à photodiode (105),
les premier et second ensembles d'éléments détecteurs linéaires (110, 120) étant agencés dans une relation superposée, les éléments détecteurs linéaires superposés respectifs (110A-D, 120A-D) des premier et second ensembles (110, 120) étant agencés dans une relation sensiblement non parallèle,
dans lequel les premier et second ensembles d'éléments détecteurs linaires (110, 120) sont placés dans ou sur un substrat (101), et
dans lequel un ou plusieurs des premiers et/ou seconds éléments détecteurs linéaires (110A-D, 120A-D) comprennent une pluralité de dispositifs à photodiode (105), **caractérisé en ce que** la pluralité de dispositifs (105) de l'un ou de plusieurs des premiers et/ou seconds éléments détecteurs linéaires (110A-D, 120A-D) sont couplés les uns aux autres en parallèle.

2. Appareil (100) selon la revendication 1, dans lequel les premier et second ensembles d'éléments détecteurs linéaires (110, 120) sont agencés, dans lesquels des projections orthogonales respectives des premier et second ensembles d'éléments détecteurs linéaires sur un plan parallèle à une face principale du substrat (101) se superposent les uns aux autres, les éléments détecteurs linéaires superposés respectifs (110, 120) étant sensiblement non parallèles.

3. Appareil (100) selon la revendication 2, dans lequel les projections orthogonales respectives se superposent sur au moins 50 % d'une surface occupée par les projections respectives.

4. Appareil (100) selon l'une quelconque des revendications précédentes, dans lequel un ou plusieurs dispositifs à photodiode (105) des premier et second ensembles (110, 120) d'un ou plusieurs éléments détecteurs linéaires sont placés à un niveau différent du substrat à un ou plusieurs autres dispositifs à photodiode (105) des premier et second ensembles (110, 120).

5. Appareil (100) selon la revendication 4, dans lequel un ou plusieurs dispositifs à photodiode (105) d'éléments détecteurs adjacents respectifs (110A-D, 120A-D) d'un ensemble donné d'éléments détecteurs linéaires (110, 120) sont fournis à différents niveaux du substrat (101).

6. Appareil (100) selon l'une quelconque des revendications précédentes, dans lequel les dispositifs à photodiode (105) des premier et second ensembles de deux ou plusieurs éléments détecteurs linéaires (110, 120) sont placés sensiblement au même niveau du substrat (101).

7. Appareil (100) selon la revendication 6, dans lequel les dispositifs à photodiode (105) des premier et second ensembles de deux ou plusieurs éléments détecteurs linéaires (110, 120) sont placés sensiblement sur le même côté du substrat (101).

8. Appareil (100) selon l'une quelconque des revendications précédentes, dans lequel des projections orthogonales de chacun des éléments détecteurs linéaires (110A-D) du premier ensemble (110) sur un plan parallèle à une face principale du substrat (101) sont sensiblement droites et sensiblement parallèles les unes aux autres,
dans lequel des projections orthogonales de chacun des éléments détecteurs linéaires (120A-D) du second ensemble (120) sur un plan parallèle à une face principale du substrat (101) sont sensiblement droites et sensiblement parallèles les unes aux autres ; et
dans lequel des projections orthogonales de chacun des éléments détecteurs linéaires (110A-D) du premier ensemble (110) sur un plan parallèle à une face principale du substrat (101) sont sensiblement orthogonales aux projections orthogonales de chacun des éléments détecteurs linéaires (120A-D) du second ensemble (120) sur ledit plan.

9. Appareil (100) selon l'une quelconque des revendications précédentes, dans lequel une projection orthogonale d'un ou plusieurs éléments détecteurs linéaires (110A-D, 120A-D) sur un plan parallèle à une face principale du substrat (101) présente au moins une partie qui est sensiblement incurvée.

10. Appareil (100) selon la revendication 9, dans lequel un ou plusieurs éléments détecteurs linéaires (110A-D, 120A-D) d'un ensemble d'éléments détecteurs linéaires (110, 120) sont sensiblement incurvés et un ou plusieurs éléments détecteurs linéaires de l'autre ensemble (120, 110) d'éléments détecteurs linéaires sont sensiblement droits.

11. Appareil (500) selon l'une des revendications 9 ou 10, dans lequel une projection orthogonale d'un ou plusieurs éléments détecteurs linéaires (510A-C) sur un plan parallèle à une face principale du substrat (101) est sensiblement sous la forme d'une boucle.

12. Appareil (100) selon l'une quelconque des revendications précédentes, conçu pour produire un signal de sortie qui correspond à la quantité de porteurs de charge générés dans un ou plusieurs ou chacun des éléments détecteurs linéaires (110A-D, 120A-D) dans une période déterminée, l'appareil (100) comprenant un ou plusieurs circuits électroniques (150) configurés pour générer le signal de sortie.

13. Appareil selon l'une quelconque des revendications précédentes comprenant en outre un second réseau d'éléments de pixels, chaque élément de pixel comprenant un ou plusieurs dispositifs de détection de rayonnement.

14. Appareil selon la revendication 13, dans lequel le second réseau comprend une pluralité de rangées et de colonnes d'éléments de pixels, chaque rangée et chaque colonne comprenant une pluralité d'éléments de pixels, dans lequel les rangées et les colonnes sont sensiblement orthogonales, dans lequel les éléments de pixels de chaque rangée et colonne sont individuellement adressables, dans lequel une quantité cumulative de charges générées dans un ou plusieurs dispositifs de détection de rayonnement de chaque élément de pixel peut être lue à partir du réseau, dans lequel les dispositifs de détection de rayonnement comprennent au moins un dispositif à photodiode.

15. Procédé de détection de rayonnement comprenant : la fourniture d'un appareil de détection (100) selon l'une quelconque des revendications précédentes ; et la détection d'un incident de rayonnement sur l'appareil (100).
